# EUROPEAN PATENT SPECIFICATION

(11) **EP 2 003 685 B1**
(45) Date of publication and mention of the grant of the patent: **18.03.2015**
(21) Application number: 07740832.6
(22) Date of filing: 02.04.2007
(51) Int. Cl.: C09J 7/02, B32B 27/32, H01L 21/304, H01L 21/683

(54) **SURFACE PROTECTIVE TAPE FOR semiconductor wafers for use during BACK GRINDING AND substrate FILM FOR THE SURFACE PROTECTIVE TAPE**
OBERFLÄCHENSCHUTZBAND FÜR Halbleiterwafer zur Verwendung beim RÜCKENSCHLIFF EINES HALBLEITERWAFERS UND TRÄGERFILM FÜR DAS OBERFLÄCHENSCHUTZBAND
BANDE DE PROTECTION DE SURFACE pour une galette semi-conductirce UTILISEE POUR RECTIFIER UNE GALETTE SEMI-CONDUCTRICE ET FILM DE BASE POUR LA BANDE DE PROTECTION DE SURFACE

(30) Priority: 03.04.2006 JP 2006101329
(43) Date of publication of application: 17.12.2008
(73) Proprietor: GUNZE LIMITED, Ayabe-shi, Kyoto 623-8511 (JP); Nitto Denko Corporation, Ibaraki Osaka 567-8680 (JP)
(72) Inventor: FUNAZAKI, Koji, Osaka-shi Osaka 530-0001 (JP); KOJIMA, Hisatomi, Moriyama-shi, Shiga 524-0064 (JP); HAYASHI, Naoya, Moriyama-shi, Shiga 524-0064 (JP); YOKOI, Masayuki, Moriyama-shi, Shiga 524-0064 (JP)
(74) Representative: Müller-Boré & Partner Patentanwälte PartG mbB
(86) International application number: PCT/JP2007/057396
(87) International publication number: WO 2007/116856

(56) References cited:
- EP-A1- 1 566 236
- WO-A1-2004/090962
- JP-A- 07 148 824
- JP-A- 2002 338 911
- JP-A- 2003 221 564
- JP-A- 2003 249 471
- JP-A- 2004 014 691

## Description

The present invention relates to a surface-protection tape for use in semiconductor wafer backgrinding (hereinafter this process may be simply referred to as backgrinding), and a substrate film for the surface-protection tape.

In a typical semiconductor production process, a circuit is formed on one surface of a semiconductor wafer by ion implantation, etching, etc., and, in order to give the wafer a predetermined thickness, a grinder, etc., is used to grind the surface of the wafer that is opposite to the surface on which the circuit was formed.

In order to prevent the semiconductor wafers from being broken during backgrinding and to facilitate the grinding process, a protective method is employed wherein a backgrinding surface-protection tape having an adhesive layer is applied to the semiconductor wafer on the surface where the circuit is formed (i.e., the front surface).

In recent years, semiconductor wafers having a very thin post-backgrinding thickness have come into demand for use in IC cards, personal digital assistants, etc. Conventional semiconductor wafers have a thickness of about 300 µm, but semiconductor wafers nowadays often have a thickness of 100 µm or less. The thinning of a semiconductor wafer reduces strength and causes breaking during backgrinding.

In view of such problems, various surface-protection tapes for use in backgrinding semiconductor wafers have been proposed.
[Patent Document 1] Japanese Unexamined Patent Publication No. H11-345790
[Patent Document 2] Japanese Unexamined Patent Publication No. 2000-8010

EP 1 566 236 A1 discloses an adhesive sheet for laser dicing, wherein the adhesive sheet has an adhesive layer at least on one side of a base material, and at least the base material surface not contacting with the adhesive layer is free from convex parts of width of 20 mm or less and height of 1 µm or more, and concave parts of width of 20 mm or less and depth of 1 µm or more.

The present inventors conducted extensive research to determine the causes of these problems, and found that the thickness accuracy of the surface-protection tape for semiconductor wafers and the presence of fish-eye defects and like foreign substances in a substrate film of the tape greatly affect the post-backgrinding thickness accuracy of the semiconductor wafer. The present inventors also found that blocking that occurs during the winding of the substrate film causes an uneven surface on the substrate film. This adversely affects the post-backgrinding thickness accuracy of the semiconductor wafers.

An object of the present invention is to provide a surface-protection tape for semiconductor wafers having an even thickness, a very smooth surface, and excellent surface sliding properties free from blocking, and a substrate film for such a surface-protection tape.

In the present specification, the surface-protection tape for semiconductor wafers refers to a tape for protecting the surface of a semiconductor wafer on which a circuit is formed (the front surface) during the backgrinding process. The surface-protection tape for semiconductor wafers comprises a substrate film for the surface-protection tape, adhesive layer, and a release film as needed.

found that the above-mentioned objects can be achieved by a substrate film for a surface-protection tape as defined in claim 1 that comprises three layers formed from specific polyethylene-based resins and has a surface roughness (Ra) and thickness accuracy within a specific range. The present invention has been accomplished based on these findings and further study.

The present invention provides a surface-protection tape for semiconductor wafers, and a substrate film for the surface-protection tape as described below.
Item 1. A substrate film for a surface-protection tape for semiconductor wafers, the substrate film having three layers containing a polyethylene-based resin, and the substrate film satisfying the following requirements:
   the substrate film being a three-layer film of a branched low-density polyethylene (LDPE)/LDPE/LDPE; a three-layer film of an ethylene/methyl methacrylate copolymer (EMMA)/LDPE/EMMA; or a three-layer film of an ethylene/vinyl acetate copolymer (EVA)/LDPE/EVA;
      (1) the back and front surfaces of the substrate film have a surface roughness Ra measured based on JIS B0601 of not more than 0.8 µm, and at least one surface thereof has a surface roughness Ra of not less than 0.05 µm; and
      (2) the difference between the maximum and minimum thicknesses of the substrate film is not more than 4 µm.
Item 2. A substrate film for a surface-protection tape for semiconductor wafers according to Item 1, wherein the substrate film is a three-layer film of LDPE/LDPE/LDPE and the back and front layers have a higher resin density than the interlayer.
Item 3. A substrate film for a surface-protection tape for semiconductor wafers according to Item 1, wherein the substrate film is a three-layer film of EMMA/LDPE/EMMA.
Item 4. A substrate film for a surface-protection tape for semiconductor wafers according to Item 1, wherein the substrate film is a three-layer film of EVA/LDPE/EVA.
Item 5. A substrate film for a surface-protection tape for semiconductor wafers according to any one of Items 1 to 4, wherein the total thickness falls within the range of 50 to 250 µm.
Item 6. A method for producing a substrate film for a surface-protection tape for semiconductor wafers, the film having three layers containing a polyethylene-based resin, and the substrate film satisfying the following requirements:
   the substrate film being a three-layer film of a branched low-density polyethylene (LDPE)/LDPE/LDPE; a three-layer film of an ethylene/methyl methacrylate copolymer (EMMA)/LDPE/EMMA; or a three-layer film of an ethylene/vinyl acetate copolymer (EVA)/LDPE/EVA;
      (1) the back and front surfaces of the substrate film have a surface roughness Ra measured based on JIS B0601 of not more than 0.8 µm, and at least one surface thereof has a surface roughness Ra of not less than 0.05 µm; and
      (2) the difference between the maximum and minimum thicknesses of the substrate film is not more than 4 µm;
   the method comprising the steps of:
      extrusion molding the film having three layers containing a polyethylene-based resin to form a molded article using a plurality of extruders so that one resin material is supplied to one extruder; and
      pressing the molded article between two members selected from the group consisting of metal rolls and metal seamless belts, the metal rolls and metal seamless belts having a surface roughness (Rz) within the range of 0.8 to 10 µm.
Item 7. A surface-protection tape for semiconductor wafers comprising the substrate film of any one of Items 1 to 5, an adhesive layer, and a release film.
Item 8. A method for backgrinding a semiconductor wafer comprising the steps of:
   removing the release film from the surface-protection tape for semiconductor wafers of Item 7;
   attaching the surface-protection tape to the front surface of the semiconductor wafer; and
   grinding the back surface of the surface-protection tape.

The present invention is described in detail below.

Examples of polyethylene-based resins usable in the present invention include ethylene homopolymers, copolymers of ethylene and methyl methacrylate, copolymers of ethylene and vinyl acetate, and mixtures thereof.

Examples of ethylene homopolymers include branched low-density polyethylenes having a short-chain branch or long-chain branch of the ethyl group. Such polyethylenes are manufactured by a high-pressure method, i.e., conducting radical polymerization of ethylene under a high pressure of not less than 1,000 atmospheres.

The branched low-density polyethylene has a density of generally 0.914 to 0.940 g/cm³, and preferably 0.921 to 0.934g/cm³. If the density is unduly low, the low-molecular-weight content increases and fisheye defects are easily formed due to thermal degradation during extrusion molding. In contrast, an unduly high density results in insufficient flexibility and a low cushioning characteristic, causing the wafer to break during the backgrinding process.

The branched low-density polyethylene has an MFR (temperature: 190°C, load: 21.2 N) of generally 0.8 to 30 g/10 minutes and preferably 2 to 10 g/10 minutes.

The density of copolymers of ethylene and methyl methacrylate is generally 0.918 to 0.945 g/cm³ and preferably 0.920 to 0.940 g/cm³. The MFR (temperature: 190°C, load: 21.2 N) thereof is generally 0.8 to 30 g/10 minutes and preferably 2 to 10 g/10 minutes.

The copolymers of ethylene and vinyl acetate preferably have a vinyl acetate content of 4 to 20 weight% and more preferably 6 to 15 weight%. The density thereof is generally 0.923 to 0.941 g/cm³ and preferably 0.925 to 0.936 g/cm³. The copolymers of ethylene and vinyl acetate have an MFR (temperature: 190°C, load: 21.2 N) of 1 to 30 g/10 minutes and preferably of 3 to 15 g/10 minutes.

Among polyethylene-based resins, branched low-density polyethylenes, ethylene/methyl methacrylate copolymers, and ethylene/vinyl acetate copolymers are preferable because they have a high melt tension when melted and achieve excellent thickness accuracy even when subjected to extrusion molding or like processing.

The use of a branched low-density polyethylene or an ethylene/methyl methacrylate copolymer makes it possible to conduct extrusion molding or like processing while adding only a small amount of antioxidant and like additives or even without adding them at all. The use of an ethylene/vinyl acetate copolymer is also advantageous in that molding or like processing can be conducted by adding a very small amount of antioxidant and like additives.

In the present specification, an antioxidant means a substance added to high polymer materials, etc., to prevent them from oxidative degradation due to the oxygen in the air under room (ordinary) temperature or heating. Examples of usable antioxidants include alkylphenols, alkylene-bisphenols, alkylphenol-thioethers, organic phosphites, aromatic amines, phenol/nickel complexes, etc.

Because such additives have a low molecular weight, they may diffuse and move inside a polymeric material, causing bleedout to the surface. Therefore, when such additives are contained in a substrate film for a surface-protection tape, it is preferable that the amount of additives be reduced as much as possible to prevent them from contaminating the semiconductor wafers. The content of an antioxidant or like additive in a substrate film for a surface-protection tape is not more than 500 ppm, preferably not more than 300 ppm, and more preferably not more than 150 ppm.

Generally, multilayered films may have 2 to 5 layers, but when the front and back surfaces have different types of resin, substrate film curling and like problems easily occur and productivity may be reduced. Therefore, symmetrical structures having 3 layers, i.e., the structures having the same type of resin on the front and back surfaces, are preferable.

When the multilayered film is formed from three or more layers of the same type of resin, by making the resin density of the front and back surfaces higher than that of the interlayer, a desirable film having excellent flexibility and blocking resistance can be obtained. In the case of a three-layer film of LDPE/LDPE/LDPE, it is preferable that the front and back layers have a resin density higher than that of the interlayer. To be more specific, it is preferable to make the density of the front and back layers, for example, 0.925 g/cm³ to 0.95 g/cm³ and that of the interlayer 0.9 g/cm³ to 0.925 g/cm³.

Blue or other pigments may be added to the substrate film for a surface-protection tape of the present invention. Specific examples of usable pigments include indanthrene pigments, phthalocyanine pigments, etc. Indanthrene pigments free from metallic elements are preferable because they do not release metal ion. The amount of the pigment added is generally less than 1 weight%, and preferably less than 0.1 weight% per total weight of the substrate film. When a pigment is added to a film having three or more layers, it is preferable that the pigment be added to the interlayer(s) rather than the front- and back-surface layers in order to prevent the contamination of the semiconductor wafer and adverse effects on the manufacturing facility caused by the bleedout of the pigment.

The total thickness of the substrate film for a surface-protection tape of the present invention is 50 to 250 µm and preferably 80 to 200 µm. If the total thickness of the substrate film is less than 50 µm, the substrate film can absorb little of the stress generated during the backgrinding process, causing wafers to be easily damaged. If the total thickness of the substrate film exceeds 250 µm, there is a tendency for the accuracy of the total thickness to be lowered.

In the present invention, the accuracy of the total thickness of the substrate film should be such that the difference between the maximum and minimum thickness is not more than 4 µm, preferably not more than 3 µm, and more preferably not more than 2 µm. The thickness difference includes projections formed by fisheye defects and like foreign substances. If the difference between the maximum and minimum thickness exceeds 4 µm, semiconductor wafers having a satisfactory thickness accuracy cannot be obtained when backgrinding. Furthermore, semiconductor wafers are subject to uneven stress during the backgrinding process, causing the semiconductor wafers to break.

The accuracy of the total thickness of the substrate film can be measured in such a manner as described in the Examples. Specifically, ten substrate films with dimensions of 400 mm x 400 mm are sampled at random, and the thickness is measured at intervals of 10 mm lengthwise and breadthwise, i.e., 1,600 points per film. The thicknesses of the nine remaining films were then measured. The measured values at a total of 16,000 points are obtained and the difference between maximum and minimum values is calculated. The thickness can be measured using, for example, a Digital Linear Gauge D-10HS manufactured by Ozaki Mfg. Co., Ltd.

In actual backgrinding, it is possible to use, for example, a circular surface-protection tape (substrate film) with a diameter of 30.5 cm (12 inches), which is the same as the diameter of the circular semiconductor wafer. In the above-described measurement method of the present invention, the thickness accuracy is measured in a plurality of substrate films having a sufficient area, and therefore its results should coincide with the actual thickness accuracy of the surface-protection tape.

There is no limitation to the ratio of thickness between each layer. For example, when the total thickness is assumed to be 100, the thickness ratio is preferably 10-40/80-20/10-40 and more preferably 20-40/60-20/20-40.

The surface roughness (Ra) on the front and back surfaces of the substrate film for a surface-protection tape of the present invention is not more than 0.8 µm, and preferably not more than 0.6 µm. If the surface roughness (Ra) exceeds 0.8 µm, the surface of the substrate film becomes too rough and a wafer having excellent thickness accuracy when backgrinding cannot be obtained. At least one surface of the substrate film for a surface-protection tape should have a surface roughness (Ra) of not less than 0.05 µm and preferably not less than 0.08 µm. If both the front and back surfaces have an Ra of less than 0.05 µm, blocking or like problems may occur when the substrate film is wound. Having an Ra of not less than 0.05 µm on at least one surface will be satisfactory. Both the front and back surfaces may have an Ra of not less than 0.05 µm at the same time.

The surface roughness (Ra) refers to the arithmetic mean deviation of the profile (arithmetic mean roughness) measured based on JIS B0601-1994.

The substrate film for a surface-protection tape of the present invention can be obtained by known methods, including an extrusion method using a T die or a cyclic die, a calendering method, etc. From the viewpoint of the thickness accuracy of the substrate film, an extrusion method using a T die is preferable. Accordingly, an extrusion method using a T die is explained below.

A polyethylene-based resin, i.e., a starting material, is supplied to a feeding hopper installed on an extruder, and melted and mixed in the extruder under heat of 160 to 240°C. The molten polyethylene-based resin is extruded from the T die into a plate-like form, solidified by cooling using a chill roll having a surface temperature of 30°C, and then wound by a winder, to obtain a rolled substrate film. When the starting material is a mixture of resins, it is preferable that the mixing be conducted before supplying the material to the feeding hopper.

According to the present invention, a plurality of extruders are used so that one resin material is supplied to one extruder.

In order to give the substrate film a specific surface roughness, the rolled substrate film obtained by the above-described method is subjected to a surface treatment in a separate process, i.e., pressing the substrate film between two members selected from the group consisting of metal rolls and metal seamless belts those having a specific surface roughness (Rz). Specifically, to obtain a specific surface roughness, the substrate film is sandwiched with pressure between two metal rolls or between a metal roll and a metal seamless belt, wherein the metal roll and metal seamless belt have a crepe-like surface and a temperature of 100 to 280°C. Subsequently, the resultant substrate film is cooled. Examples of materials for the metal roll include steel and stainless steel. Examples of materials for the metal seamless belt include nickel and stainless steel. Steel is preferable for the metal roll and nickel is preferable for the metal seamless belt. It is desirable that the metal roll and metal seamless belt be chrome plated.

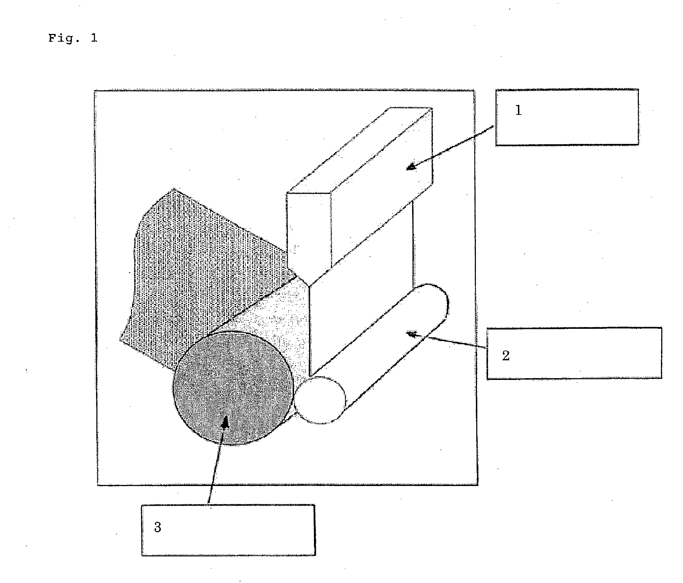

A substrate film can also be obtained in the following manner. A multilayered plate-like molded article (having a thickness of 50 µm to 250 µm and a temperature of 150° C to 230°C) is extruded from a T die and immediately pressed between two metal rolls or between a metal roll and a metal seamless belt those having a crepe-like surface, while cooling (Fig. 1). Since the number of steps can be reduced, conducting the surface treatment while extrusion molding is preferable.

In the present invention, the surface roughness (Rz) of the metal roll and the metal seamless belt is generally 0.8 to 10 µm, and preferably 1 to 8 µm. If the surface roughness (Rz) of the metal roll and the metal seamless belt falls within the above range, a substrate film having a surface roughness (Ra) of 0.05 to 0.8 µm can be obtained.

The surface roughness (Rz) refers to a ten-point average height measured based on JIS B0601-1994.

In order to improve the thickness accuracy of the substrate film, a method wherein the substrate film is wound after being pressed between two metal rolls, or between a metal roll and a metal seamless belt is preferable. Uneven thickness due to local projections caused by foreign substances, such as a fisheye defect cannot be prevented in extrusion molding; however, by pressing the film between two metal rolls or between a metal roll and a metal seamless belt, projections can be pressed into the film. This makes it possible to bury the surface projections inside the film.

The thus-obtained substrate film for a surface-protection tape has excellent thickness accuracy and desirable surface roughness.

The substrate film for a surface-protection tape can be used for a surface-protection tape by providing an adhesive layer thereon. Usually, a release film is provided on an adhesive layer.

A surface-protection tape is obtained by applying a known adhesive to the surface of the substrate film for a surface-protection tape to form an adhesive layer, and then providing a release film on the adhesive layer. In other words, an adhesive layer and a release film are formed on the first layer of the substrate film for a surface-protection tape.

The thickness of the adhesive layer is, for example, 10 µm to 200 µm, and that of a release film is, for example, 10 µm to 100 µm.

Known adhesive components are usable for the materials of the adhesive layer, including those disclosed in Japanese Unexamined Patent Publication No. H5-211234. The release film may also be formed of known components.

Acrylic adhesives are preferably used for forming the adhesive layer. Specific examples thereof include acrylic polymers selected from homopolymers and copolymers having a (meth)acrylic acid ester as a main constituent monomeric unit, copolymers of acrylic polymer and other functional monomer, and mixtures of these polymers. Preferable examples of (meth)acrylic acid esters include ethyl methacrylate, butyl methacrylate, 2-ethylhexyl methacrylate, glycidyl methacrylate, 2-hydroxyethyl methacrylate, ethyl acrylate, butyl acrylate, 2-ethylhexyl acrylate, glycidyl acrylate, 2-hydroxyethyl acrylate, etc. The acrylic polymers have a molecular weight of generally 1.0 x 10⁵ to 10.0 x 10⁵ and preferably 4.0 x 10⁵ to 8.0 x 10⁵.

By mixing a radiation polymerizable compound into the above-mentioned adhesive layer, the adhesive strength can be reduced after grinding the back surface of the semiconductor wafer by irradiating the adhesive layer. Examples of widely used radiation polymerizable compounds include low-molecular-weight compounds having at least two photopolymerizable carbon-carbon double bonds that can be three-dimensionally reticulated by irradiating with light (for example, Japanese Unexamined Patent Publication No.S60-196956, Japanese Unexamined Patent Publication No.S60-223139, etc.).

Specific examples of radiation polymerizable compounds include trimethylolpropane triacrylate, tetramethylolmethane tetraacrylate, pentaerythritol triacrylate, pentaerythritol tetraacrylate, dipentaerythritol monohydroxy pentaacrylate, dipentaerythritol hexaacrylate, 1,4-butylene glycol diacrylate, 1,6-hexanediol diacrylate, polyethylene glycol diacrylate, commercially available oligoester acrylates, etc.

Other than these acrylate compounds, urethane acrylate oligomers may be used as a radiation polymerizable compound. Such urethane acrylate oligomers can be obtained by reacting a terminal isocyanate urethane prepolymer obtained by a reaction between a polyester type or a polyether type of polyol compound and a multivalent isocyanate compound with an acrylate or a methacrylate having a hydroxyl group. The thus-obtained urethane acrylate oligomer is a radiation polymerizable compound having at least one carbon-carbon double bond.

Furthermore, in addition to these adhesives and radiation polymerizable compounds, the adhesive layer may comprise, if necessary, a compound colored by being irradiated (using a leuco dye, etc.), light-scattering inorganic compound powder, abrasive grains (with a particle diameter of 0.5 µm to 100 µm), an isocyanate curing agent, UV initiator, etc.

In most cases, a surface-protection tape film is formed into a tape-like shape and obtained in a wound condition.

A method for backgrinding a semiconductor wafer using the above-described surface-protection tape is explained below. After removing the release film from the adhesive layer on the surface-protection tape to expose the surface of the adhesive layer, the surface-protection tape is attached, via the adhesive layer, to the surface (where an integrated circuit is formed) of a semiconductor wafer. The thickness of a semiconductor wafer before backgrinding is generally 300 µm to 1000 µm. Subsequently, the semiconductor is fixed and ground on the back surface by a standard method. The thickness of a semiconductor wafer after backgrinding varies depending on the size of the chip, the type of circuit, the usage thereof, etc., but is generally about 50 µm to about 200 µm. After the backgrinding process, a chemical etching process or a CMP (chemical-mechanical polishing) process may be conducted if necessary. Thereafter, the adhesive film is removed. If necessary, after removing the adhesive film, the semiconductor wafer surface may be washed with water or subjected to plasma treatment.

The substrate film for a surface-protection tape of the present invention has a uniform thickness accuracy, is free from surface projections caused by fisheye defects and like foreign substances, and has excellent surface accuracy. The substrate film has a desirable surface roughness on at least one surface. This allows the substrate film to be easily handled, and prevents blocking, etc. Therefore, a very high surface accuracy can be maintained even in the final substrate film form.

The surface-protection tape of the present invention comprises an adhesive layer and a substrate film for a surface-protection tape those having the above-mentioned excellent properties. When this surface-protection tape is applied, backgrinding can be conducted without breaking the semiconductor wafer even when the semiconductor wafer is very thin. Furthermore, the thus-obtained semiconductor wafer has excellent thickness accuracy.

Figure 1 is a schematic diagram illustrating one embodiment of treating the surface of a substrate film for a surface-protection tape.

### [Explanation of reference numerals]

1 T die
2 Metal roll
3 Metal roll

The present invention is illustrated in detail below with reference to Examples and Comparative Examples. The surface roughness Ra and Rz, and thickness accuracy in the Examples were obtained in the following manner.

### [Surface roughness of film (Ra: arithmetic mean roughness)]

The surface roughness of the thus-obtained substrate film for a surface-protection tape was measured based on JIS B0610 using a Surfcom 570A (product of Tokyo Seimitsu Co., Ltd.), wherein the cutoff was 0.8 mm, the speed for driving the measurement element was 0.3 mm/second, and the measurement length was 2.5 mm.

### [Surface roughness of metal roll (Rz: ten-point average height)]

The surface roughness of the metal roll was measured based on JIS B0610.

### [Thickness accuracy]

Ten substrate films with dimensions of 400 mm x 400 mm were sampled at random, and the thickness of one film was measured at intervals of 10 mm lengthwise and breadthwise, i.e., 1,600 points per film, using a Digital Linear Gauge D-10HS manufactured by Ozaki Mfg. Co., Ltd. The thicknesses of the nine remaining films were then measured. The measured values at the total of 16,000 points were obtained and the difference between the maximum and minimum values was calculated.

### (Example 1 as a reference example)

A branched low-density polyethylene (product name: F522N manufactured by Ube Maruzen Co., Ltd., density = 0.922 g/cm³, MFR = 5, without additives) was fed into an extruder having a temperature of 230°C and melted. The molten polyethylene was extruded from a T die at 230°C into a plate-like shape with a thickness of 120 µm, and then pressed between a metal roll having a surface temperature of 30°C and a surface roughness Rz of 1.2 µm and a metal seamless belt having a surface temperature of 20°C and a surface roughness Rz of 3.8 µm. The resultant molten article was solidified by cooling and wound by a winder, to obtain a single-layer film having a thickness of 120 µm (see Fig. 1). Using samples obtained from the resultant film, the surface roughness and thickness accuracy were measured. Table 1 shows the results.

### (Example 4)

A film was obtained in the same manner as in Example 1 except that a branched low-density polyethylene (product name: F522N manufactured by Ube Maruzen Co., Ltd., density = 0.922 g/cm³, MFR = 5, without additives) was used as a material for layer A and an ethylene/methyl methacrylate copolymer (product name: WD203-1 manufactured by Sumitomo Chemical Co., Ltd., density = 0.92 g/cm³, MFR = 2, methyl methacrylate content = 5 weight%, and antioxidant content = 1,000 ppm) was used as a material for layer B. The materials for layers A and B were fed into separate extruders, and a three-layered film (B/A/B) having thicknesses of 20 µm/80 µm/20 µm was obtained. Using samples obtained from the resultant film, the surface roughness and thickness accuracy were measured. Table 1 shows the results.

### (Example 5)

A film was obtained in the same manner as in Example 1 except that a branched low-density polyethylene (product name: F522N manufactured by Ube Maruzen Co., Ltd., density = 0.922 g/cm³, MFR = 5, without additives) was used as a material for layer A and a branched low-density polyethylene (product name: Z372 manufactured by Ube Maruzen Co., Ltd., density = 0.934 g/cm³, MFR = 5) was used as a material for layer B. The materials for layers A and B were fed into separate extruders, and a three-layered film (B/A/B) having thicknesses of 20 µm/80 µm/20 µm was obtained. Using samples obtained from the resultant film, the surface roughness and thickness accuracy were measured. Table 1 shows the results.

### (Example 6)

A film was obtained in the same manner as in Example 1 except that a branched low-density polyethylene (product name: F522N manufactured by Ube Maruzen Co., Ltd., density = 0.922 g/cm³, MFR = 5, without additives) was used as a material for layer A and an ethylene/vinyl acetate copolymer (product name: Ultrasen 541 manufactured by Tosoh Corporation, density = 0.929 g/cm³, MFR = 9) was used as a material for layer B. The materials for layers A and B were fed into separate extruders, and a three-layered film (B/A/B) having thicknesses of 20 µm/80 µm/20 µm was obtained. Using samples obtained from the resultant film, the surface roughness and thickness accuracy were measured. Table 1 shows the results.

### (Example 7 as a reference example)

A film was obtained in the same manner as in Example 1 except that the rolls used for pressing and solidification by cooling were a metal roll 1 having a surface roughness Rz of 1.2 µm and a metal seamless belt having a mirror surface. Using samples obtained from the resultant film, the surface roughness and thickness accuracy were measured. Table 1 shows the results.

### (Comparative Example 1)

A film was obtained in the same manner as in Example 1 except that an ethylene/methacrylic acid copolymer (product name: Nucrel AN4214C manufactured by Du Pont-Mitsui Polychemicals Co., Ltd., density = 0.93 g/cm³, MFR = 7, methacrylic acid content = 4 weight%) was used as a material. The resultant film had very large fisheye defects that could not be buried in the film even by being pressed between the metal roll and the metal seamless belt, and resulted in a film having thick portions at which fisheye defects were formed. Using samples obtained from the resultant film, the surface roughness and thickness accuracy were measured. Table 1 shows the results.

### (Comparative Example 2)

A film was obtained in the same manner as in Example 1 except that an ethylene/ethyl acrylate copolymer (product name: Evaflex EEA A701 manufactured by Du Pont-Mitsui Polychemicals Co., Ltd., density = 0.92 g/cm³, MFR = 5, ethyl acrylate content = 9 weight%) was used as a material. The resultant film had very large fisheye defects that could not be buried in the film even by being pressed between the metal roll and the metal seamless belt, and resulted in a film having thick portions at which fisheye defects were formed. Using samples obtained from the resultant film, the surface roughness and thickness accuracy were measured. Table 1 shows the results.

### (Comparative Example 3)

A film was obtained in the same manner as in Example 1 except that the rolls used for pressing and solidification by cooling were a metal roll 1 having a mirror surface and a metal seamless belt having a mirror surface. Because the film was not easily removed from the metal roll, stable film formation was difficult. The resultant film had low surface roughness on the front and back surfaces, which resulted in poor slippage of the film. This made the resultant film difficult to handle. Using samples obtained from the resultant film, the surface roughness and thickness accuracy were measured. Table 1 shows the results.

**Table 1**

| | Example 1 | Example 4 | Example 5 | Example 6 | Example 7 | Comp. Ex. 1 | Comp. Ex. 2 | Comp. Ex. 3 |
|---|---|---|---|---|---|---|---|---|
| Component | | EMMA | LDPE | EVA | | | | |
| | LDPE | LDPE | LDPE | LDPE | LDPE | EMAA | EEA | LDPE |
| | | EMMA | LDPE | EVA | | | | |
| Thickness (µm) | 120 | 20/80/20 | 20/80/20 | 20/80/20 | 120 | 120 | 120 | 120 |
| Press roll 1 | Metal roll (Rz 1.2) | | | | | | | Mirror surface roll |
| Press roll 2 | Metal seamless belt (Rz 3.8) | | | | Mirror surface belt | Metal seamless belt (Rz 3.8) | | Mirror surface metal seamless belt |
| Sheet roughness Ra 1 | 0.12 | 0.12 | 0.12 | 0.12 | 0.12 | 0.12 | 0.12 | |
| Sheet roughness Ra 2 | 0.30 | 0.30 | 0.30 | 0.30 | 0.01 | 0.30 | 0.30 | |
| Thickness accuracy (µm) | 2.1 | 2.9 | ' 2.2 | 2.4 | 2.1 | 8.5 | 10.5 | |
| Film formation property | Excellent | Excellent | Excellent | Excellent | Excellent | Excellent | Excellent | Difficult due to uneven releasability from metal roll |
| Handling easiness | Excellent | Excellent | Excellent | Excellent | Excellent | Excellent | Excellent | Difficult due to poor slippage |
| Fisheye projections | None | None | None | None | None | Some conspicuous projections | Some conspicuous projections | None |

| | | | | | | | | |
|---|---|---|---|---|---|---|---|---|
| *LDPE: branched low-density polyethylene *EMMA: ethylene/methyl methacrylate copolymer *EVA : ethylene/vinyl acetate copolymer *EMAA: ethylene/methacrylic acid copolymer *EEA : ethylene/ethyl acrylate copolymer | | | | | | | | |

### (Test Example 1)

### Backgrinding evaluation

An adhesive was applied to the films obtained in the Examples and Comparative Examples to obtain adhesive tapes. The thus-formed adhesive tapes were attached to the surface of a silicon mirror wafer (with a diameter of 8 inches and a thickness of 700 µm) using a tape attaching device (Model 3250 manufactured by Hugle Electronics Inc.). The resultant tape attached wafer was then ground using a grinder (DFG-810 manufactured by DISCO Corporation) to a thickness of 150 µm. The occurrence of breaking and/or cracks in the wafer was then observed. In Table 2, "A" indicates that no breaking or cracks were found by visual observation, and "B" indicates that breaking or cracks were observed.

**Table 2**

| | Example 1 | Example 4 | Example 5 | Example 6 | Example 7 | Comp. Ex. 1 | Comp. Ex. 2 | Comp. Ex. 3 |
|---|---|---|---|---|---|---|---|---|
| Breaking | A | A | A | A | A | B | B | A |
| Cracks | A | A | A | A | A | B | B | A |

## Claims

1. A substrate film for a surface-protection tape for semiconductor wafers,
the substrate film having three layers containing a polyethylene-based resin, and the substrate film satisfying the following requirements:
the substrate film being a three-layer film of a branched low-density polyethylene (LDPE)/LDPE/LDPE; a three-layer film of an ethylene/methyl methacrylate copolymer (EMMA)/LDPE/EMMA; or a three-layer film of an ethylene/vinyl acetate copolymer (EVA)/LDPE/EVA;
(1) the back and front surfaces of the substrate film have a surface roughness Ra measured based on JIS B0601 of not more than 0.8 µm, and at least one surface thereof has a surface roughness Ra of not less than 0.05 µm; and
(2) the difference between the maximum and minimum thicknesses of the substrate film is not more than 4 µm.

2. The substrate film for a surface-protection tape for semiconductor wafers according to Claim 1, wherein the substrate film is a three-layer film of LDPE/LDPE/LDPE and the back and front layers have a higher resin density than the interlayer.

3. The substrate film for a surface-protection tape for semiconductor wafers according to Claim 1, wherein the substrate film is a three-layer film of EMMA/LDPE/EMMA.

4. The substrate film for a surface-protection tape for semiconductor wafers according to Claim 1, wherein the substrate film is a three-layer film of EVA/LDPE/EVA.

5. The substrate film for a surface-protection tape for semiconductor wafers according to any one of Claims 1 to 4, wherein the total thickness falls within the range of 50 to 250 µm.

6. A method for producing a substrate film for a surface-protection tape for semiconductor wafers,
the film having three layers containing a polyethylene-based resin, and the substrate film satisfying the following requirements:
the substrate film being a three-layer film of a branched low-density polyethylene (LDPE)/LDPE/LDPE; a three-layer film of an ethylene/methyl methacrylate copolymer (EMMA)/LDPE/EMMA; or a three-layer film of an ethylene/vinyl acetate copolymer (EVA)/LDPE/EVA;
(1) the back and front surfaces of the substrate film have a surface roughness Ra measured based on JIS B0601 of not more than 0.8 µm, and at least one surface thereof has a surface roughness Ra of not less than 0.05 µm; and
(2) the difference between the maximum and minimum thicknesses of the substrate film is not more than 4 µm;
the method comprising the steps of:
extrusion molding the film having three layers containing a polyethylene-based resin to form a molded article using a plurality of extruders so that one resin material is supplied to one extruder; and
pressing the molded article between two members selected from the group consisting of metal rolls and metal seamless belts, the metal rolls and metal seamless belts having a surface roughness (Rz) within the range of 0.8 to 10 µm.

7. A surface-protection tape for semiconductor wafers comprising the substrate film of any one of Claims 1 to 5, an adhesive layer, and a release film.

8. A method for backgrinding a semiconductor wafer comprising the steps of:
removing the release film from the surface-protection tape for semiconductor wafers of Claim 7;
attaching the surface-protection tape to the front surface of the semiconductor wafer; and
grinding the back surface of the surface-protection tape.

## Patentansprüche

1. Trägerfolie für ein Oberflächenschutzband für Halbleiterwafer,
wobei die Trägerfolie drei Schichten aufweist, die ein Polyethylen-basiertes Harz enthalten, und die Trägerfolie die folgenden Bedingungen erfüllt:
die Trägerfolie ist eine dreischichtige Folie aus einem verzweigten Polyethylen geringer Dichte (LDPE)/LDPE/LDPE; eine dreischichtige Folie aus einem Ethylen/Methylmethacrylat Copolymer (EMMA)/LDPE/EMMA; oder eine dreischichtige Folie aus einem Ethylen/Vinylacetat Copolymer (EVA)/LDPE/EVA;
(1) die rückseitige und die vorderseitige Oberfläche der Trägerfolie weisen eine Oberflächenrauheit Ra, gemessen auf Basis von JIS B0601, von nicht mehr als 0,8 µm auf und mindestens eine Oberfläche davon weist eine Oberflächenrauheit Ra von nicht weniger als 0,05 µm auf; und
(2) der Unterschied zwischen der maximalen und der minimalen Dicke der Trägerfolie ist nicht mehr als 4 µm.

2. Trägerfolie für ein Oberflächenschutzband für Halbleiterwafer nach Anspruch 1, wobei die Trägerfolie eine dreischichtige Folie aus LDPE/LDPE/LDPE ist und die rückseitige und die vorderseitige Schicht eine höhere Harzdichte als die Zwischenschicht aufweisen.

3. Trägerfolie für ein Oberflächenschutzband für Halbleiterwafer nach Anspruch 1, wobei die Trägerfolie eine dreischichtige Folie aus EMMA/LDPE/EMMA ist.

4. Trägerfolie für ein Oberflächenschutzband für Halbleiterwafer nach Anspruch 1, wobei die Trägerfolie eine dreischichtige Folie aus EVA/LDPE/EVA ist.

5. Trägerfolie für ein Oberflächenschutzband für Halbleiterwafer nach einem der Ansprüche 1 bis 4, wobei die Gesamtdicke in den Bereich von 50 bis 250 µm fällt.

6. Verfahren zur Herstellung einer Trägerfolie für ein Oberflächenschutzband für Halbleiterwafer,
wobei die Folie drei Schichten aufweist, die ein Polyethylen-basiertes Harz enthalten, und die Trägerfolie die folgenden Bedingungen erfüllt:
die Trägerfolie ist eine dreischichtige Folie aus einem verzweigten Polyethylen geringer Dichte (LDPE)/LDPE/LDPE; eine dreischichtige Folie aus einem Ethylen/Methylmethacrylat Copolymer (EMMA)/LDPE/EMMA; oder eine dreischichtige Folie aus einem Ethylen/Vinylacetat Copolymer (EVA)/LDPE/EVA;
(1) die rückseitige und die vorderseitige Oberfläche der Trägerfolie weisen eine Oberflächenrauheit Ra, gemessen auf Basis von JIS B0601, von nicht mehr als 0,8 µm auf und mindestens eine Oberfläche davon weist eine Oberflächenrauheit Ra von nicht weniger als 0,05 µm auf; und
(2) der Unterschied zwischen der maximalen und der minimalen Dicke der Trägerfolie ist nicht mehr als 4 µm;
das Verfahren umfasst die Schritte des:
Stangpressens der Folie mit drei Schichten, die ein Polyethylen-basiertes Harz enthalten, unter Verwendung einer Mehrzahl an Extrudern, so dass ein Harzmaterial einem Extruder bereitgestellt wird, um ein Formteil zu bilden; und
Pressens des Formteils zwischen zwei Mitglieder, ausgewählt aus der Gruppe, bestehend aus Metallrollen und nahtlosen Metallbändern, wobei die Metallrollen und die nahtlosen Metallbänder eine Oberflächenrauheit (Rz) innerhalb des Bereichs von 0,8 bis 10 µm aufweisen.

7. Oberflächenschutzband für Halbleiterwafer, umfassend die Trägerfolie nach einem der Ansprüche 1 bis 5, eine Klebeschicht und eine Trennfolie.

8. Verfahren zum Rückseitenschleifen eines Halbleiterwafers, umfassend die Schritte des:
Entfernens der Trennfolie von dem Oberflächenschutzband für Halbleiterwafer nach Anspruch 7;
Anbringens des Oberflächenschutzbands an die vorderseitige Oberfläche des Halbeiterwafers; und
Schleifens der rückseitigen Oberfläche des Oberflächenschutzbands.

## Revendications

1. Film faisant office de substrat pour un ruban de protection de surface pour des semi-conducteurs étagés, le film faisant office de substrat possédant trois couches contenant une résine à base de polyéthylène et le film faisant office de substrat répondant aux exigences indiquées ci-après, le film faisant office de substrat représentant un film constitué par trois couches à base d'un polyéthylène basse densité ramifié (LDPE)/LDPE/LDPE ; un film constitué par trois couches à base d'un copolymère d'éthylène/méthacrylate de méthyle (EMMA)/LDPE/EMMA ; ou un film constitué par trois couches à base d'un copolymère d'éthylène/acétate de vinyle (EVA)/LDPE/EVA : (1) les surfaces dorsale et frontale du film faisant office de substrat possèdent une rugosité superficielle Ra mesurée en se basant sur la norme JIS B0601 qui n'est pas supérieure à 0,8 µm et au moins une desdites surfaces possède une rugosité de surface Ra qui n'est pas inférieure à 0,05 µm ; et (2) la différence entre l'épaisseur maximale et l'épaisseur minimale du film faisant office de substrat n'est pas supérieure à 4 µm.

2. Film faisant office de substrat pour un ruban de protection de surface pour des semi-conducteurs étagés selon la revendication 1, dans lequel le film faisant office de substrat représente un film constitué par trois couches à base de LDPE/LDPE/LDPE et les couches dorsale et frontale possèdent une densité de résine qui est supérieure à celle de la couche intermédiaire.

3. Film faisant office de substrat pour un ruban de protection de surface pour des semi-conducteurs étagés selon la revendication 1, dans lequel le film faisant office de substrat représente un film constitué par trois couches à base de EMMA/LDPE/EMMA.

4. Film faisant office de substrat pour un ruban de protection de surface pour des semi-conducteurs étagés selon la revendication 1, dans lequel le film faisant office de substrat représente un film constitué par trois couches à base de EVA/LDPE/EVA.

5. Film faisant office de substrat pour un ruban de protection de surface pour des semi-conducteurs étagés selon l'une quelconque des revendications 1 à 4, dans lequel l'épaisseur totale rentre dans la plage de 50 à 250 µm.

6. Procédé de production d'un film faisant office de substrat pour un ruban de protection de surface pour des semi-conducteurs étagés, le film possédant trois couches contenant une résine à base de polyéthylène et le film faisant office de substrat répondant aux exigences indiquées ci-après, le film faisant office de substrat représentant un film constitué par trois couches à base d'un polyéthylène basse densité ramifié (LDPE)/LDPE/LDPE ; un film constitué par trois couches à base d'un copolymère d'éthylène/méthacrylate de méthyle (EMMA)/LDPE/EMMA ; ou un film constitué par trois couches à base d'un copolymère d'éthylène/acétate de vinyle (EVA)/LDPE/EVA : (1) les surfaces dorsale et frontale du film faisant office de substrat possèdent une rugosité superficielle Ra mesurée en se basant sur la norme JIS B0601 qui n'est pas supérieure à 0,8 µm et au moins une desdites surfaces possèdent une rugosité de surface Ra qui n'est pas inférieure à 0,05 µm ; et (2) la différence entre l'épaisseur maximale et l'épaisseur minimale du film faisant office de substrat n'est pas supérieure à 4 µm, le procédé comprenant les étapes consistant à : mouler par extrusion le film possédant trois couches contenant une résine à base de polyéthylène pour obtenir un article moulé en utilisant plusieurs extrudeuses de telle sorte qu'une matière de résine alimente une extrudeuse ; et comprimer l'article moulé entre deux membres choisis parmi le groupe constitué par des cylindres métalliques et des courroies métalliques continues, les cylindres métalliques et les courroies métalliques continues possédant une rugosité de surface (Rz) dans la plage de 0,8 à 10 µm.

7. Ruban de protection de surface pour des semi-conducteurs étagés comprenant le film faisant office de substrat selon l'une quelconque des revendications 1 à 5, une couche adhésive et une pellicule protectrice autocollante.

8. Procédé pour la rectification dorsale d'un semi-conducteur étagé comprenant les étapes consistant à : retirer la pellicule protectrice autocollante du ruban de protection de surface pour des semi-conducteurs étagés selon la revendication 7 ; fixer le ruban de protection de surface à la surface frontale du semi-conducteur étagé ; et rectifier la surface dorsale du ruban de protection de surface.
